# EUROPEAN PATENT SPECIFICATION

(11) **EP 0 945 001 B1**
(45) Date of publication and mention of the grant of the patent: **23.04.2003**
(21) Application number: 97943643.3
(22) Date of filing: 30.09.1997
(51) Int. Cl.: H04N 5/44, H04N 5/46

(54) **A MULTIPLE FORMAT VIDEO SIGNAL PROCESSOR**
VIDEOSIGNALPROZESSOR FÜR VERSCHIEDENE FORMATE
PROCESSEUR DE SIGNAL VIDEO A FORMATS MULTIPLES

(30) Priority: 18.12.1996 EP 96402785
(43) Date of publication of application: 29.09.1999
(73) Proprietor: THOMSON CONSUMER ELECTRONICS, INC., Indianapolis, IN 46290-1024 (US)
(72) Inventor: SCHULTZ, Mark, Alan, Carmel, IN 46033 (US); KRANAWETTER, Greg, Alan, Mission Viejo, CA 92692 (US)
(74) Representative: Hartnack, Wolfgang, Dipl.-Ing.
(86) International application number: US9717512
(87) International publication number: WO98027720

(56) References cited:
- US-A- 5 264 931
- US-A- 5 448 300
- US-A- 5 448 307

## Description

### Field of the Invention

This invention relates to processing video signals for display.

### Background Information

Compressed video signal transmission systems, for example systems using an MPEG-2 (Motion Picture Experts Group) compression format ("Coding of Moving Pictures and Associated Audio," ISO/IEC JTC1/SC29/WG11 **N0702** (revised), May 10, 1994), are currently broadcasting HDTV (High Definition Television) digital signals from a number of test sites. Commercial program broadcasts are scheduled to begin soon as the first HDTV sets come to market. HDTV signals are not compatible with current television receivers, such as those for processing NTSC standard signals in the United States. Therefore, a transition period will occur during which SD (standard definition) television signals according to the NTSC or PAL television standards will continue to be broadcast so as to prevent SD sets from becoming immediately obsolete. Also for a period of time, some programming will not be available in MPEG format because of changeover logistics broadcasters will encounter.

Video data is transmitted in different formats (e.g. 4:3 and 16:9 picture display aspect ratios; 4:4:4, 4:2:2, and 4:2:0 data sample formats; interlaced and non-interlaced scanned) and with different spatial resolution (e.g. 352, 480, 544, 640, 720...1920 pixels per line and 240, 480, 720, 1080 active lines per frame). It is generally impractical, for both aesthetic and cost reasons, to equip video signal receivers with the ability to display decompressed signals in their pre-transmission format. Rather, post decompression processing circuitry is preferably included to transcode different formats of a decompressed video signal to a desired display format.

There are many transcoding or spatio-temporal conversion systems known to those skilled in the art of video signal processing. In general, each is directed to a specific type of conversion, such as interlace to non-interlace conversion, or sample, line, or field rate doubling.

Even though video decompression systems incorporate an appreciable amount of circuitry, it is desirable to employ additional circuitry to process non-compressed or standard definition video signals. Post processing circuitry included in the receiver should transcode an SD video signal without significantly increasing the amount of transcoding circuitry. This is difficult because digital MPEG formatted television signals arrive at an MPEG compatible display processor in decoded pixel block format SD television signals generally arrive at the display processor as multiplexed analog YC_{R}C_{B} display-ready pixel lines (a raster scan) in a 4:2:2 ratio in either NTSC or PAL format.

It is known in the art to employ digital interpolation techniques for raster mapping of video signals, see D. Gillies et al., "Combined TV Format Control and Sampling Rate Conversion IC", 1 August 1994, IEEE Transactions on Consumer Electronics, Vol. 40, No. 3, pp. 711-716, XP000471240. However, such systems do not provide for processing of both HDTV and SD signals for storage or display.

### Summary

In accordance with the present invention, an input accepts MPEG formatted television signals and decodes them into a pixel block format. The system also accepts SD television signals, in either NTSC, PAL or SECAM format, which are rearranged into pixel blocks acceptable to the display processor. The display processor accepts pixel block formatted video data and produces display drive signals.

### Brief Description of the Drawings

In the drawings:
Figure 1 is a block diagram of an embodiment of the present invention.
Figure 2A is a block diagram of an SD/HDTV MPEG decoder and display processing circuit employing the present invention.
Figure 2B is a block diagram showing an embodiment of an MPEG decompressor as used in Figure 2A.
Figure 2C is a block diagram of the display processor of Figure 2A.
Figure 3 illustrates an example of line-to-block conversion.
Figures 4A and 4B through 8A and 8B illustrate various signal format conversions implemented by the decoder circuit.
Figure 9 is a flow chart of the signal path through a receiver including a decoder according to the present invention.

### Description of the Preferred Embodiment

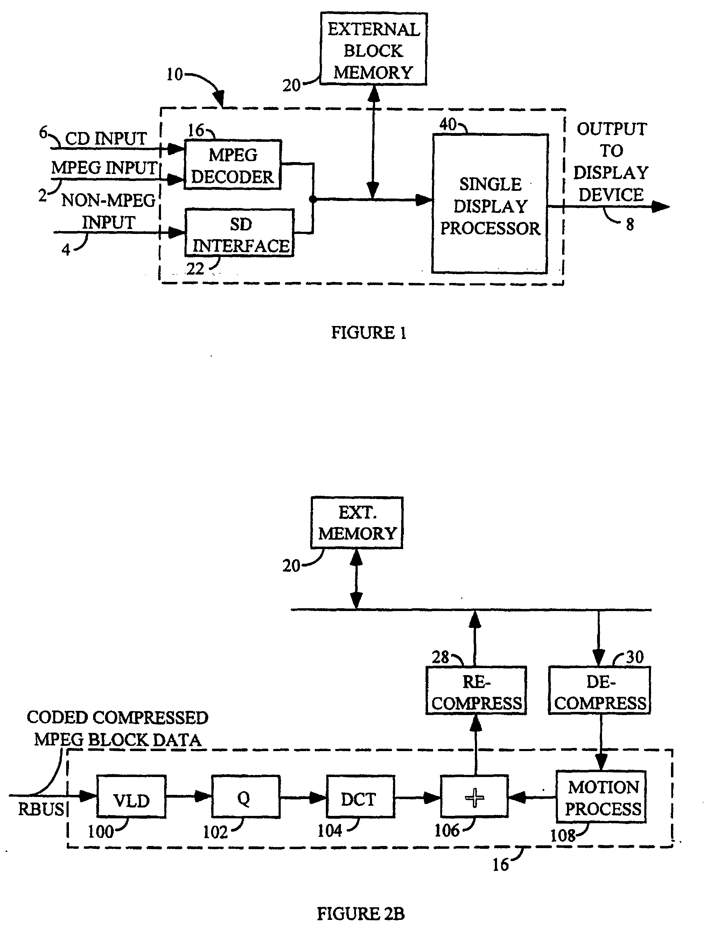

Figure 1 illustrates the basic elements of the preferred embodiment of the invention. Compressed MPEG data from CD Input and from MPEG Input provide compressed MPEG data to MPEG Decoder 16. Decoded MPEG data is provided to Block Memory 20 and to display processor 40. Standard definition data, for example, NTSC formatted broadcast data, is received by SD Interface 22 which accepts line data and converts it to block data. Block Memory 20 and the same display processor 40 receive standard definition data in block format from SD Interface 22. Display processor 40 receives block data from both sources and provides block-to-line conyersion and aspect and ratio conversion formatted to a desired display device. The bus structure between elements 16, 20, 22, and 40 may be a common bus as shown, or separate buses connecting each of elements 16 and 22 to both elements 20 and 40.

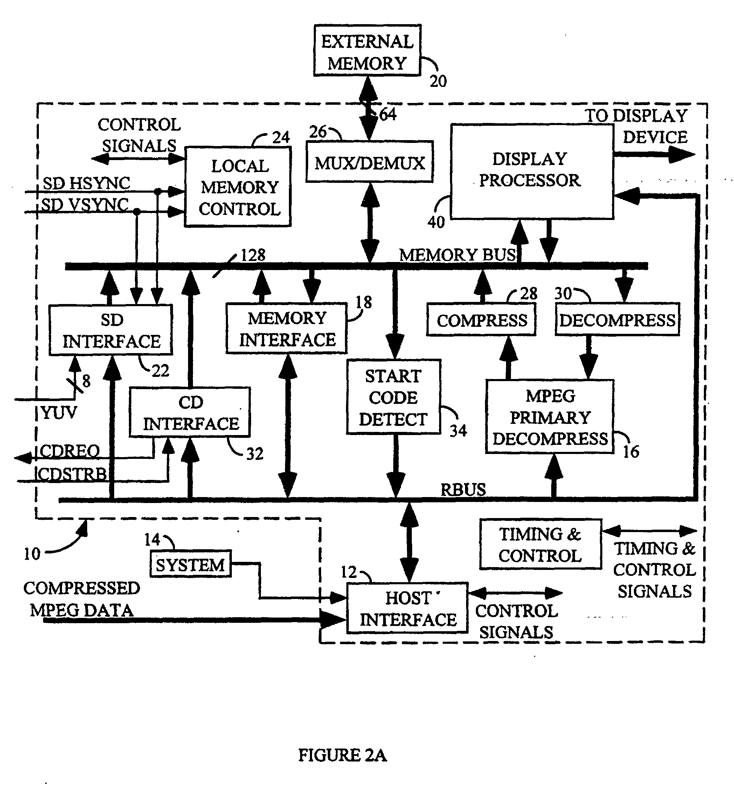

Figure 2A shows a block diagram of a portion of a compressed video signal decoder including display processing circuitry for transforming signals occurring in different formats to a preferred format or formats. All of the illustrated circuitry, except possibly the external memory and the system control, may be included in a single integrated circuit, although it is not necessary to practice the invention. The apparatus in Figure 2A may be included in, for example, an Advanced Television Receiver (ATV), including Tuner/IF circuitry, Deinterleaving circuitry, Error Correction circuitry, and Inverse Transport circuitry for providing, e.g., an MPEG compressed digital video signal. The Figure 2A apparatus assumes that the television receiver will provide, e.g., component NTSC, PAL or SECAM signals (all referred to as SD) in a digital format such as CCIR601. In addition, the Figure 2A apparatus receives and decodes compressed video signals from other sources which may transmit at constant and variable rates, both continuously and in bursts. Other data formats may be input to decoder 10 by adding a converter to provide the signal in an acceptable format Such data formats may be those known in the computer industry, RGB, VGA, SVGA, etc., for example.

Decoder 10 includes an input interface 12 which couples external compressed video data other than SD video data to the decoder. For example, input interface 12 is coupled to an overall system controller 14, to an MPEG primary decompressor 16 and to a memory interface 18.
The compressed video data may be HD MPEG formatted data, for example. Input interface 12 couples external data and control signals to various parts of decoder 10 through an RBUS which is 21 bits wide in this example. The compressed video data are retrieved from MPEG formatted packets and buffered in external memory 20 prior to decompression.

Standard definition digital video is applied directly from an external source to an SD interface 22 via an 8-bit bus designated SD DATA BUS. SD data are received in a digital raster line format, i.e., line-by-line. SD interface 22 operates under the control of an LMC 24 (local memory controller), passes the SD data to external memory 20 as pixel block data compatible with the input requirements of a display processor 40. Since the SD data are line formatted pixel representations, the pixel data are simply reorganized by position into pixel blocks rather than transformed or converted into some other representation, such as by a discrete cosine transformation. LMC 24 is a fast controller which rearranges the lines of pixels to pixel blocks compatible with MPEG compatible display processor 40. LMC 24 is primarily a hardware controller which includes partial reorganization of the data by software. Converting SD data to pixel blocks advantageously allows both SD data and decompressed MPEG data to be processed by the same display processor.

SD interface 22 is simpler and less costly than bypassing display processor 40 or providing a second compatible display processor. Bypassing requires reprogramming and reconfiguring many of the elements in display processor 40 to handle when SD data is received, because pixel block data is not processed the same as raster line data. SD interface 22 is an uncomplicated element which handles certain tasks which otherwise would be handled by system controller 14. These tasks include receiving and counting the number of pixels per line, ensuring the correct amount or information is always output to external memory 20, and not outputting data during blanking periods. Furthermore, LMC 24 requires only a simple algorithm to direct the reorganization of data received by SD interface 22.

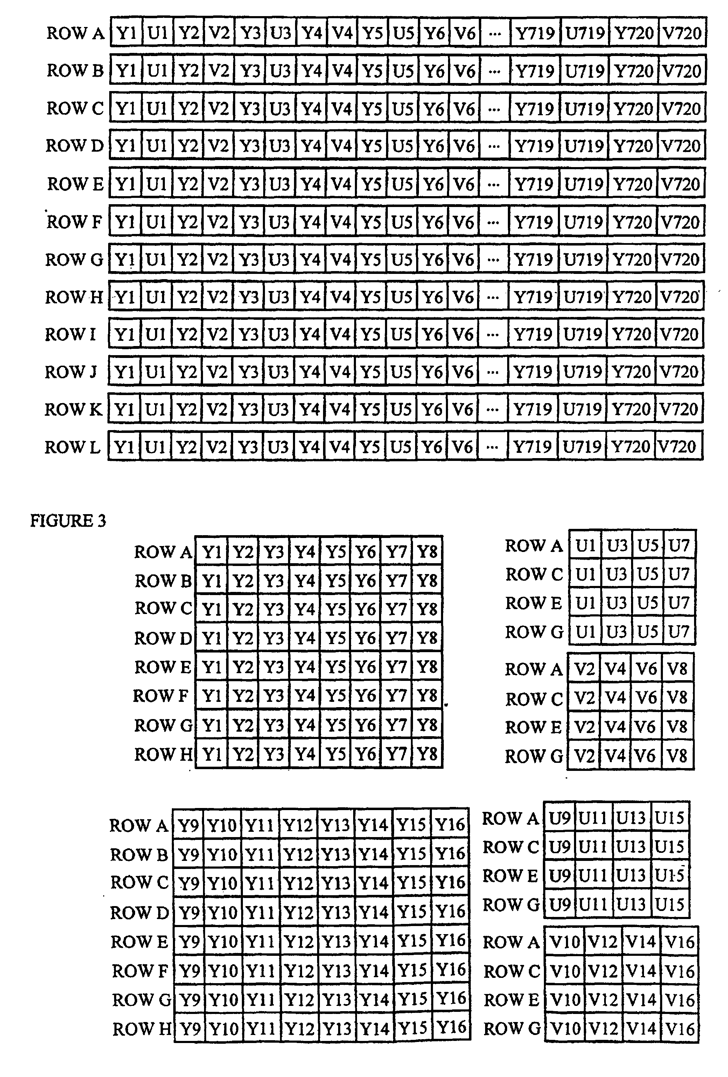

Figure 3 illustrates one example of data reorganization from line form to block form. Generally, data received by SD Interface 22 is in digital form. However, a converter (not shown) may easily be added at or prior to the input of SD Interface 22 to convert the data to digital form when necessary. Rows A through L represent pixel data having 4:2:2 aspect ratio and raster line format. The data rows continue according to the received data format. SD Interface 22 reorganizes the data by separating luminance and U and V chrominance values. Luminance data are grouped in 8X8 blocks and U and V chrominance data are grouped into 4X4 blocks. The chrominance data blocks include odd data positions in the U block and even positions in the V block. Also, conversion from a 4:2:2 to a 4:2:0 aspect ratio occurred during the reorganization, however aspect ratio conversion will depend upon the display device input data requirements. The reorganized data is stored as blocks in external memory 20.

Compressed data which may only appear once, which may be received at a variable rate, or which may be received in bursts are received by decoder 10 on a priority CD (compressed data) interface 32. When data are present at CD interface 32, decoder 10 prioritizes the interface activity to ensure proper reception. CD interface 32 accepts compressed video data in MPEG compatible format. CD interface 32 includes a buffer with an 8-bit input and a 128-bit output which translates the data and sends it to external memory 20 prior to decompression.

External memory 20 also connects externally to decoder 10, and may be as large as 96 Mbits for high definition television signals. The connection is a 64-bit bus coupled through a multiplexer/demultiplexer 26. Unit 26 translates data from a 128-bit internal memory data bus (MEM BUS) to the 64-bit memory bus. LMC 24 controls read/write of external memory 20 at the request of the various interfaces and the various processing circuitry. LMC 24 is programmed to store video data in memory 20 in block format, where a block comports with an MPEG structured block of 8x8 pixel data.

Decoder 10 uses external frame memory 20 as a receiving and timing buffer for compressed video data because of its storage capacity. A large storage space is needed to buffer incoming data prior to decompression. Putting this buffer in an integrated circuit disadvantageously occupies significant physical space. Also, buffering facilitates pixel block formation for frame reconstruction. Overhead information is stripped off by start code detector 34 which obtains information needed for decompression.

Compressed input video data is retrieved from external memory 20 for initial decompression and applied via the MEM BUS to MPEG decompressor 16. Other forms of decompression may be utilized without affecting the spirit the present invention. MPEG decompression of predicted frames requires that previously decompressed "anchor" frames be stored in memory and retrieved when needed to decompress and reconstruct an image. The apparatus of Figure 2A incorporates secondary compression of decompressed MPEG video data before complete frames are stored in memory 20, thereby significantly reducing the amount of external memory required in the receiver. Secondary compression is hereinafter referred to as recompression.

The first compression, and subsequent decompression, is the formatting of data in MPEG format for broadcast in a transport stream. Figure 2B is an example of an MPEG decompressor. Decompressor 16 of Figure 2A is expanded to show the necessary generic element an MPEG decompressor. Coded, compressed MPEG data is received on RBUS by VLD (variable length decoder) 100. VLD 100 passes decoded data to inverse quantizer 102, which passes unquantized data to inverse discrete transform processor 104 which produces MPEG decompressed block-based data. This data is combined with data from motion processor 108 in combiner 106 and passed to recompressor 28.

Recompressor 28 is different from MPEG compression in an MPEG encoder, and may be practiced in many forms. For example the recompression may include differential pulse code modulation on a block basis and subsequent fixed, variable, or run length coding. Alternatively it may incorporate Huffman coding on a block basis. Compression may be lossless or lossy.

Recompression is performed in Figure 2A by a compressor 28 coupled between MPEG decompressor 16 and the MEM BUS. Thus, MPEG decoded and decompressed video data are applied to compressor 28 for data recompression followed by storage in external memory 20. When recompressed video data are retrieved for reconstructing MPEG predicted frames in a motion processing network, they are first applied to a decompressor 30, which operates inversely to compressor 28. The retrieved data, after passing through decompressor 30, is in condition for use by MPEG decoder 10 for reconstructing predicted frames in the course of motion compensation processing.

Both HD recompressed video frames and SD video frames are retrieved from external memory 20 and applied to display processor 40 via the MEM BUS for processing prior to display or storage as component signals with a desired aspect ratio and display resolution. Data retrieved from external memory 20 is applied to display processor 40 through FIFO's 42, 44, 46, 48, 50 which perform two functions. The first is time buffering of the data. The second is converting sixteen-byte wide data (128 bits) from the MEM BUS, to one-byte wide data (MPEG data to decompressor 52) or to four-byte wide data (SD data to LMU 54). The designated byte widths are exemplary.

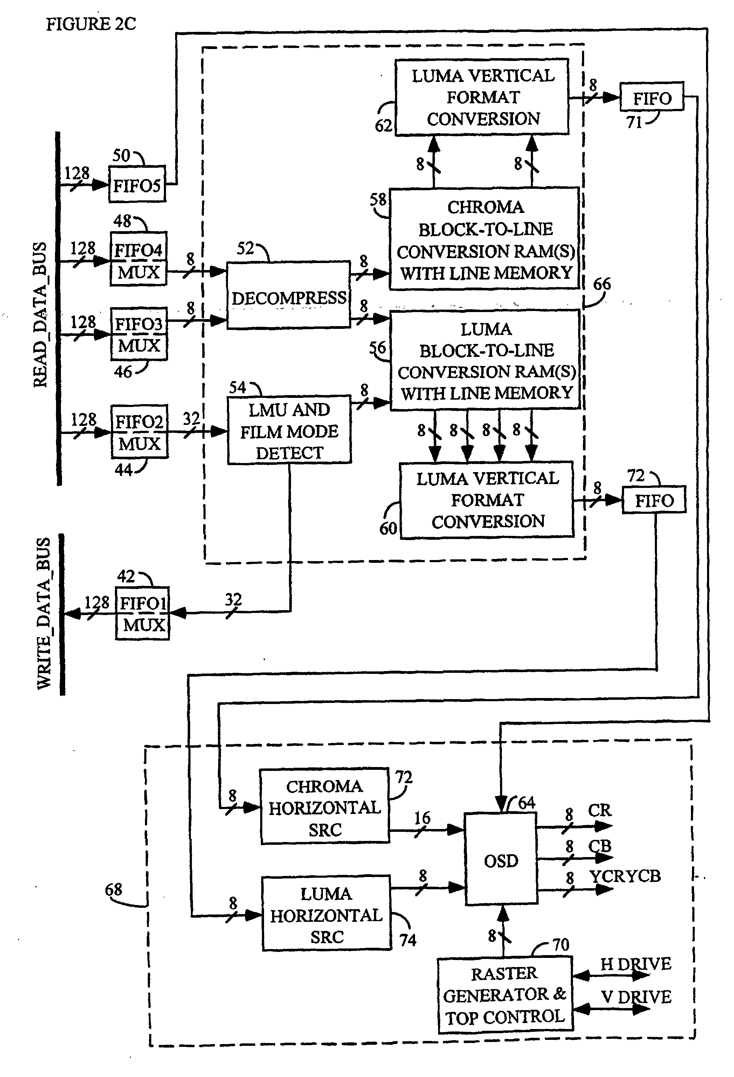

Display processor 40 is shown in Figure 2C. In display processor 40, recompressed MPEG video data is first applied to decompressor 52, which is similar to decompressor 30. Decompressor 52 provides decompressed video luminance (Y) and chrominance (C) video component signals on a block-by-block basis. Decompressed MPEG component signals from decompressor 52 are applied to respective luminance and chrominance block-to-line converters 56 and 58. The block-to-line converters apply Y and C component signals on a line-by-line basis to a luma sample rate converter (LUMA SRC 60) and a to chroma sample rate converter (CHROMA SRC 62) respectively. Both luma and chroma rate converters 60, 62 include circuitry for vertical format conversion and horizontal sample rate conversion. Vertical and horizontal converters are separated by FIFO's to handle timing transitions between the converters.

The sample rate converters are programmable in accordance with the parameters of a particular system, and may increase or decrease the number of lines per picture, and/or increase or decrease the number of pixels per line. Luma and chroma component data from the sample rate converters are coupled to an on-screen display (OSD 64) which is selectively conditioned as known to overlay text and/or graphics on the component video signals. Either system controller 14 or the input data stream may provide OSD data which is stored in external memory 20, though not on a block basis.

Decoder 10 advantageously includes circuitry for deinterlacing SD picture formats and generating an up-sampled 1125 line total (1080 active lines) interlace scan output, or a 480 (active) line progressive scan output. This circuitry is located in LMU 54. The SD picture format has 480 active interlace scan lines. To provide the appearance of higher vertical resolution for display on a high resolution monitor, the output is increased to at least 480 active progressive lines (960 active interlace lines also acceptable?). The remaining active lines (1080 less 960) may be black.

LMU 54 (Linear Motion-adaptive Upconverter) performs the line conversion required by the output image display device. The SD signal is stored in and subsequently retrieved from external memory 20 because LMU 54 requires an SD signal concurrently from adjacent frames to calculate image motion. This is not motion compensation as it is known in an MPEG format. For each field, associated lines pass through LMU 54, which estimates lines interstitial to field lines based upon the amount of image motion. Image motion is estimated from differences between corresponding pixel values in the previous field and frame. If motion values are generally zero, then the interlace line from the previous field is used as the estimated line. If a high degree of motion exists near the interstitial line, then the interstitial line is estimated from the average of the line above and the line below the interstitial line in the current field. If only a small degree of motion exists, then the interstitial line is estimated from a combination of the line in the previous field and averaged lines from the current field. The more motion present, the more the average of the lines above and below the current line from the current field is used relative to the interlace scan line from the previous field. Rather than constrain memory 20 to provide adjacent lines for line averaging, memory internal to luma block-to-line converter 60 is advantageously utilized to concurrently provide video signal from adjacent lines to LMU 54. Furthermore, LMU 54 may clarify frames with filters and line and/or field delays based upon motion occurring within the frame.

Data may be applied to and from the MEM BUS via FIFO memories internal to processing elements (not shown to simplify the drawing). Elements of Figure 2A have input and/or output FIFO's which allow decoder 10 to function in a seamless manner. By loading a segment of data into the buffers/FIFO's, each element may process resident data independent of system controller 14, which may devote itself to other tasks.

The display processor has two separate clocks controlling separate sections, the decompress clock domain 66 and the display clock domain 68. The decompress clock domain 66 contains all the functions which must interface synchronously with block-to-line conversion RAM's 56, 58, and must run at 40 to 81 MHz clock rates to achieve the desired bandwidth. Display clock domain 68 contains functions which must run synchronously with the final output at clock rates from 27 to 81 MHz. The two clocks may operate at the same rate or at a different rate, depending upon the application. Video data passing between the two clock domains passes through FIFO's 71, 73 (one each for luma and chroma) with the read request for the FIFO's coming from the horizontal sample rate converter controller.

Each FIFO includes control logic responsive to read and write acknowledge and request signals from display processor 40 and LMC 24. Control logic also exists to track the amount of data in the respective FIFO, and to control the asynchronous interface between the "bus" end of the FIFO, which uses the same clock as the data bus, and the "display" end of the FIFO which uses the display clock. Since the display section contains the control logic the amount of circuitry actually operating off the "bus" clock is desirably minimized.

The vertical format conversion process places several constraints on LMC 24, because display data is not always required in a continuous or uniform manner. In this exemplary embodiment, there exists a memory pointer, an active line register, an upper field start register, and a lower field start register for each of the video data paths (FIFO3- FIFO5). The upper and lower field start registers are set by the host bus to the address of the first frame line to be read, where line 0 corresponds to the first active line of the frame. At the beginning of each upper or lower field, data from the corresponding field start register transfers to the active line register.

At the start of each display line, LMC 24 uses the contents of the active line register to calculate a physical memory address (using the first significant bit to select the appropriate field, if fields are stored separately). The result is loaded into the memory pointer, and the FIFO's are reset and filled with data corresponding to the specified display scan line. During the line interval, additional data is fetched as required by modifying the memory pointer. During the same line interval the active line register is incremented by n, where n = 0,...,7. The vertical format converter provides a new value of n for each line for each FIFO.

When performing format conversion, FIFO2 44 is used to access control words for LMU 54. Each control word is contained within a 128 bit word of external memory 20. Separate upper and lower field start registers are required for this function as well, but only one 128 bit word is used for each display line. A signal from LMU 54 instructs LMC 24 to get the next line's control-word from either the next successive memory location or from the location specified by the field start register.

The primary or MPEG decompressed data (but secondarily recompressed data) is accessed from external memory 20 on a block by block basis, and applied via FIFO3 46 and FIFO4 48 to luma and chroma secondary decompressors which provide decompressed luma and chroma pixel block values. The blocks of decompressed luma and chroma pixel values are applied to respective block-to-line converters 56 and 58 comprising local RAM memories. Entire rows of 8x8 blocks (luma) or 4x4 blocks (chroma) are written to the respective local memories. The memories are read out line by line or by multiple lines in parallel depending on the instant function of converter circuitry connected to the memory output memory. As data is read, new data is written into that location to minimize the amount of local memory required. Exemplary sizes for local memories of block to line converters 56 and 58 are 8-bytes wide by 120-bytes deep and 8-bytes wide by 240-bytes deep. Local memories include input multiplexers and output multiplexers to arrange the input data into 8-byte wide data for storage in the local memory, and to appropriately arrange the 8-byte wide data read from memory for use by the respective vertical sample rate converter.

The horizontal and vertical sample rate converters for processing decompressed MPEG video to be displayed on a high definition 16:9 display will perform the line conversions listed in tables I and II respectively. The horizontal converter should be capable of a maximum pixel output rate of 81 MHz.

**TABLE I:**

| HORIZONTAL CONVERSIONS | |
|---|---|
| INPUT FORMAT | OUTPUT FORMAT |
| 352, 480, 544, 640, 720, 1280, 1920 | 1920 |
| 352, 480, 544, 640, 720, 960 | 960 |
| 352, 480, 544, 640, 720, | 720 |

**TABLE II:**

| VERTICAL CONVERSIONS | |
|---|---|
| INPUT FORMAT | OUTPUT FORMAT |
| 720 Progressive | 480 Interlace, 480 Progressive, 1080 Interlace |
| 1080 Interlace | 480 Interlace, 480 Progressive |
| 240 CIF | 480 Interlace, 480 Progressive, 1080 Interlace |

Tables I and II describes luma signal conversions. Similar conversions are performed on chroma signals. Regarding chroma, the compressed signal is in 4:2:0 format, and the foregoing chroma conversions include an additional conversion from 4:2:0 to 4:2:2. Usually this chroma processing will be included with any other required vertical processing. For chroma conversion, a two-tap polyphase filter is generally employed for the combined resampling and the 4:2:0 to 4:2:2 conversion.

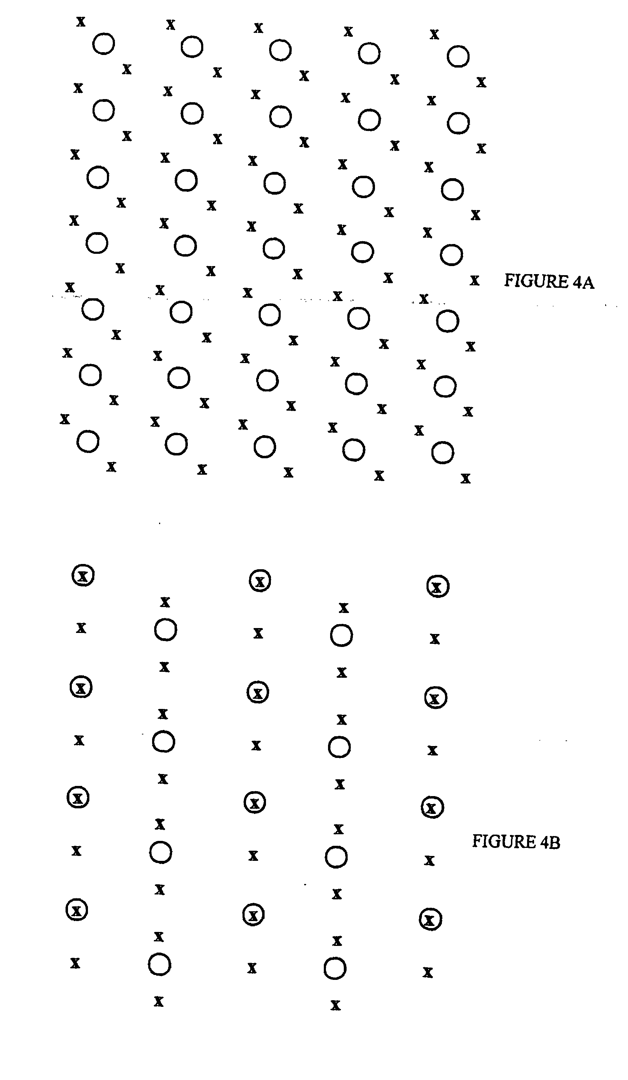

For Figures 4 through 8 it may appear that the X's and O's are not aligned or incorrectly overlap. Whereas the figures do approximate the placement, the general relationship of X to O is correct. The apparent misalignment or overlap is correct and occurs because of the non-integer ratio of the conversion.

Figures 4A and 4B illustrate pictorially the vertical/temporal relationship of input and output chrominance lines when 4:2:0 to 4:2:2 only conversion is required (i.e. receive 480 progressive and display 480 interlace or receive 1080 progressive and display 1080 interlace). Figures 4A and 4B represent a portion of the lines in a field. The circles represent the original pixels in 4:2:0 format. The "X's" represent pixels of the converted 4:2:2 signal. Interpolated lines in every field are calculated from the lines in the respective field.

Figure 4A shows a frame based display where all chroma lines are used to generate the first or top field, and then again to generate the second or bottom field. Figure 4B shows a field based display. In this case, the even chroma lines (starting with line 0) are used to generate the first or top field, and the odd chroma lines are used to generate the second or bottom field.

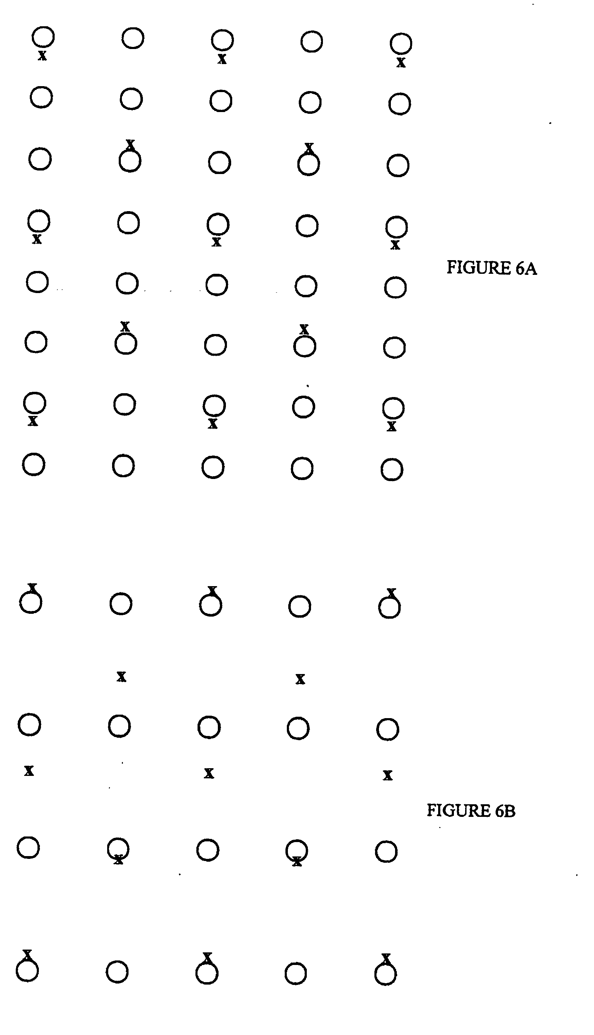

Figures 5A and 6A illustrate luma conversion options in a form similar to that described with respect to Figure 2A. Figure 5A illustrates the vertical and temporal relationship of input and output luma lines when 720 progressive format is converted to 1080 interlace format. Figure 6A illustrates the vertical and temporal relationship of input and output luma lines when 720 progressive format is converted to 480 interlace format.

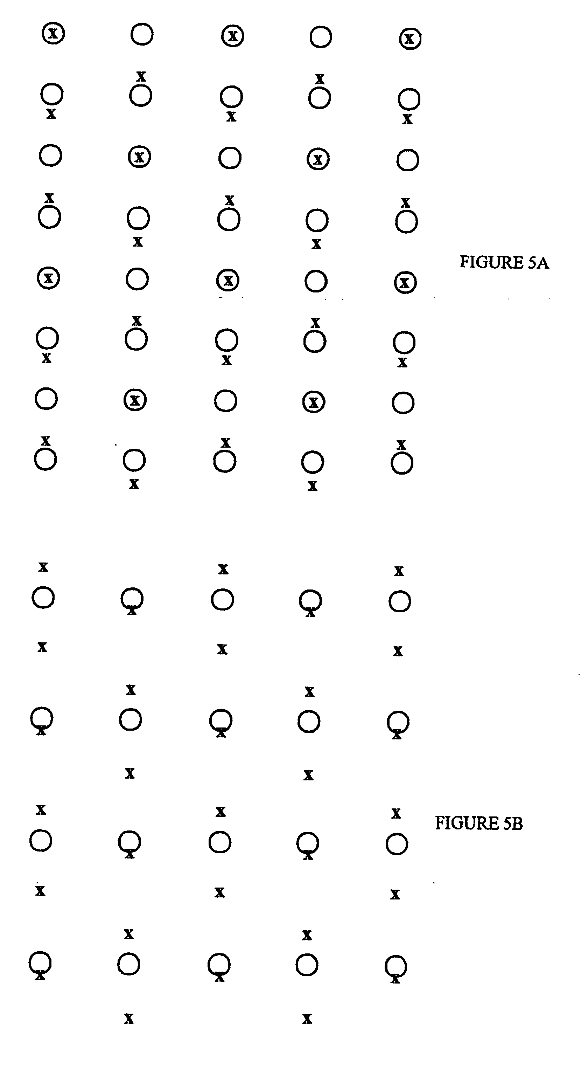

Figures 5B and 6B illustrate corresponding chroma conversion options relative to the luma conversions described above. Figure 5B shows the vertical and temporal relationship of input and output chroma lines when 720 progressive format is converted to 1080 interlace format. Figure 6B shows the vertical and temporal relationship of input and output chroma lines when 720 progressive format is converted to 480 interlace format.

No temporal processing is included in these exemplary conversions. Luma and chroma processing occurs only in the vertical direction. Furthermore, the input chroma information is frame based and only frame based 4:2:0 to 4:2:2 conversion need be considered.

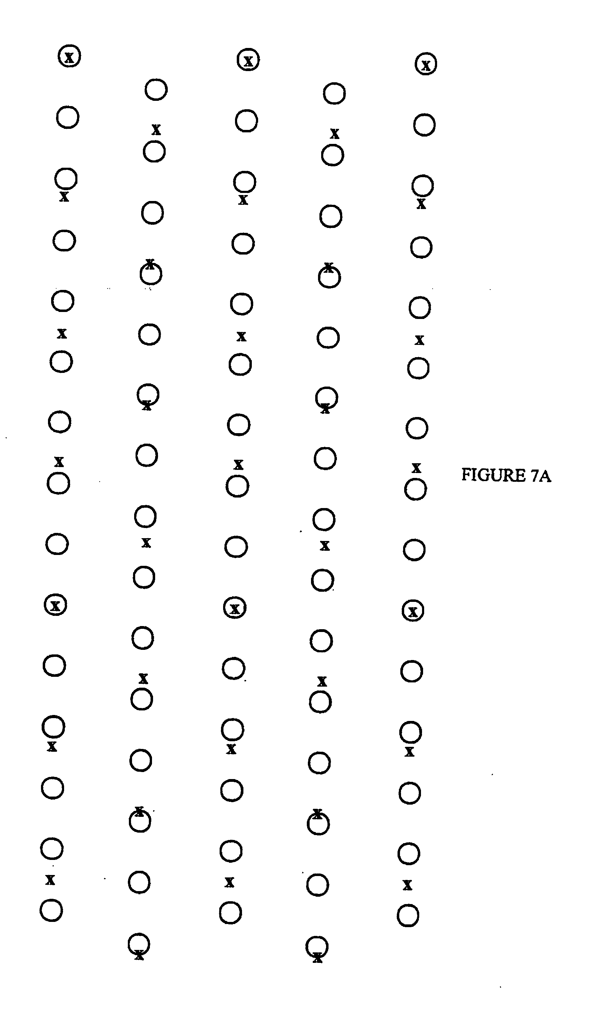

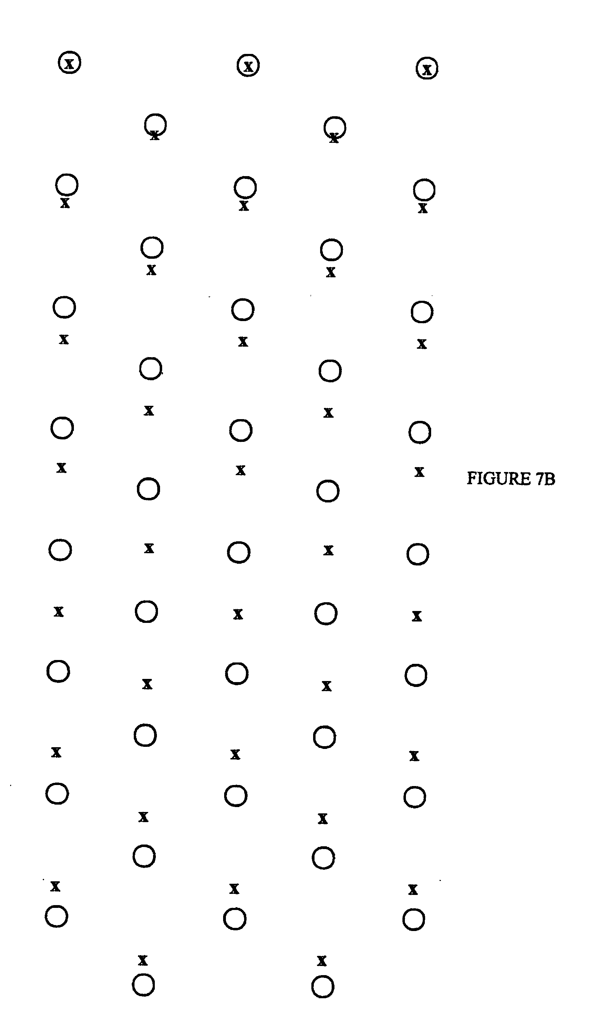

Figures 7A and 7B are different Figure 7A shows the vertical and temporal relationship of input and output luminance lines when 1080 interlaced format is converted to 480 interlace format. Figure 7B shows the vertical and temporal relationship of input and output chrominance lines when 1080 interlaced format is converted to 480 interlaced format.

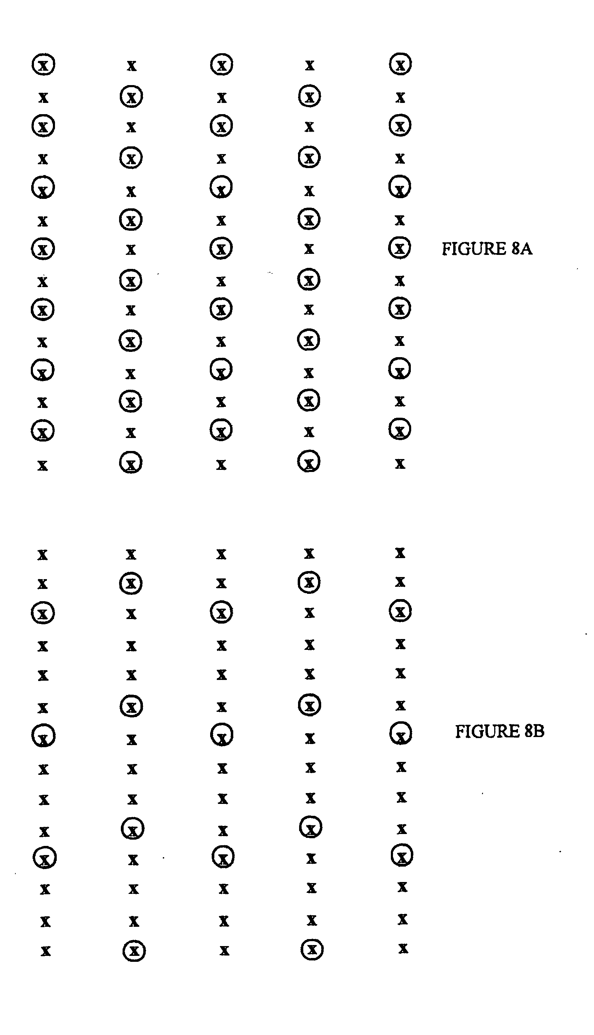

Figures 8A and 8B pictorially illustrate the luminance and chrominance vertical conversions, respectively, of SD video signal performed by LMU 54. Recall that vertical and temporal processing is included in these conversions rather than vertical only processing. Typically, operation of the deinterlacing algorithm is only required for image sizes up to 720x480 interlaced (i.e. CCIR601 resolution). These images can originate from the MPEG decoding process or as input from the SD input port.

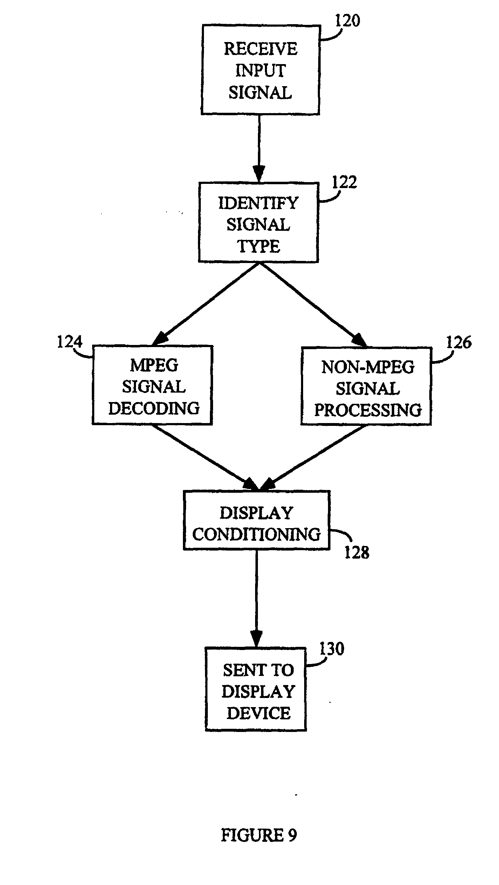

Figure 9 is a flow chart of the signal path through a receiver including a decoder according to the principles of the present invention. The input signal is received by the receiver in block 120. The input signal is formatted as an MPEG or non-MPEG compatible signal as described above. The signal format is identified in block 122 and directed to the proper processing path. If the signal format is MPEG compatible, the signal is decoded as described above in block 124, and block data compatible with the display processor is produced. If the signal is not MPEG compatible, the signal is processed as described above in block 124, which also produces block data compatible with the display processor. The display processor compatible block data is passed to the display processor which produces data formatted and compatible with a particular display device, or potentially another storage device, in block 128. Finally, the display compatible data is sent to the display device or storage medium in block 130.

## Claims

1. Digital video signal processing system including:
- an input (2) for receiving MPEG HD format data;
- an input (4) for receiving non-MPEG SD format data;
- a display processor (40), including a block-to-line converter (56), for processing block format MPEG data and line-to-block converted (22) non-MPEG format data;
- means for reformatting (54) the SD signal to an HD signal, and decompressing both the SD and HD formatted data;
- an output (8) for conveying data from said display processor to a display device.

2. System according to claim 1, wherein said block-to-line converter is a luminance block-to-line converter (56) and wherein said display processor (40) also includes a chrominance block-to-line converter (58).

3. Method for processing multiple format video signals, including the steps of:
- receiving (120) a signal comprising data to be processed;
- identifying (122) said received signal as one of MPEG HD format signal and non-MPEG SD format signal;
- decoding (124) input MPEG format signal to produce block format data when received;
- pre-processing (126) input non-MPEG format signal to produce block format data when received;
- conditioning (128) said conveyed data to a format suitable for display by reformatting the SD signal to an HD signal and decompressing both the SD and HD formatted data;
- conveying (130) the display conditioned data to a display device.

4. Method according to claim 3, wherein said pre-processing step (126) converts line format data to block format data.

5. Method according to claim 3 or 4, wherein said conditioning step (128) converts block format data to line format data.

6. Method according to claim 3, 4 or 5, further comprising the step of writing block format data to a memory (20) and reading block format data from said memory prior to said display conditioning step.

## Patentansprüche

1. Digitales Videosignal-Verarbeitungssystem, enthaltend:
einen Eingang (2) zum Empfang von MPEG-HD-Format-Daten; einen Eingang (4) zum Empfang von nicht-MPEG-SD-Format-Daten;
einen Anzeigeprozessor (40), der einen Block-in-Zeilen-Konverter (56) enthält, um MPEG-Daten mit Block-Format und
von Zeilen in Blöcke umgewandelte (22) Nicht-MPEG-Format-Daten zu verarbeiten;
Mittel (54) zum Reformatieren des SD-Signals in ein HD-Signal, und Dekomprimieren der formatierten SD- und HD-Daten;
einen Ausgang (8) zum Überführen der Daten von dem Anzeigeprozessor zu einer Anzeigevorrichtung.

2. System nach Anspruch 1, bei dem der Block-in-Zeilen-Konverter ein Luminanz-Block-in-Zeilen-Konverter (56) ist, und bei dem der Anzeigeprozessor (40) auch einen Chrominanz-Block-in-Zeilen-Konverter (58) enthält.

3. Verfahren zum Verarbeiten von Videosignalen mit mehreren Formaten, das die Schritte enthält:
- Empfangen (120) eines Signals, das zu verarbeitende Daten umfasst;
- Identifizieren (122) des empfangenen Signals als ein MPEG-HD-Format-Signal oder als ein Nicht-MPEG-SD-Format-Signal;
- Dekodieren (124) eines Eingangssignals mit MPEG-Format, wenn es empfangen wird, um Daten mit Block-Format zu erzeugen;
- Vor-Verarbeiten (126) eines Eingangssignals mit Nicht-MPEG-Format, wenn es empfangen wird, um Daten mit Block-Format zu erzeugen;
- Konditionieren (128) der überführten Daten auf ein für die Anzeige geeignetes Format durch Reformatieren des SD-Signals auf ein HD-Signal und Dekomprimieren der formatierten SD- und HD-Daten;
- Überführen (130) der für die Anzeige konditionierten Daten zu einer Anzeigevorrichtung.

4. Verfahren nach Anspruch 3, bei dem der Vor-Verarbeitungs-Schritt (126) Daten mit Zeilen-Format in Daten mit Block-Format umwandelt.

5. Verfahren nach Anspruch 3 oder 4, bei dem der Konditionierungs-Schritt (128) Daten mit Block-Format in Daten mit Zeilen-Format umwandelt.

6. Verfahren nach Anspruch 3, 4 oder 5, das ferner den Schritt umfasst, Daten mit Block-Format in einen Speicher (20) zu schreiben und Daten mit Block-Format vor dem Konditionierungs-Schritt für die Anzeige aus dem Speicher zu lesen.

## Revendications

1. Système de traitement de signaux vidéo numériques comportant :
- une entrée (2) pour recevoir des données au format HD MPEG ;
- une entrée (4) pour recevoir des données au format DS non MPEG ;
- un processeur d'affichage (40), comportant un convertisseur de blocs en lignes (56), pour traiter des données MPEG formatées en blocs et des données au format non MPEG converties de lignes en blocs (22) ;
- un moyen de reformatage (54) du signal DS en un signal HD, et un moyen de décompression des données au format à la fois DS et HD ;
- une sortie (8) pour acheminer des données depuis ledit processeur d'affichage jusqu'à un dispositif d'affichage.

2. Système selon la revendication 1, dans lequel le convertisseur de blocs en lignes est un convertisseur de blocs en lignes de luminance (56) et dans lequel ledit processeur d'affichage (40) comporte aussi un convertisseur de blocs en lignes de chrominance (58).

3. Procédé de traitement de signaux vidéo aux formats multiples, comportant les étapes de :
- réception (120) d'un signal comprenant des données à traiter ;
- identification (122) dudit signal reçu comme un signal au format HD MPEG et un signal au format DS non MPEG ;
- décodage (124) du signal au format MPEG d'entrée afin de produire des données formatées en blocs à sa réception ;
- prétraitement (126) du signal au format non MPEG d'entrée afin de produire des données formatées en blocs à sa réception ;
- conditionnement (128) desdites données acheminées en un format convenant à l'affichage en reformatant le signal DS en un signal HD et en décompressant les données à la fois aux formats DS et HD ;
- acheminement (130) des données conditionnées d'affichage vers un dispositif d'affichage.

4. Procédé selon la revendication 3, dans lequel ladite étape de prétraitement (126) convertit des données formatées en lignes en des données formatées en blocs.

5. Procédé selon la revendication 3 ou 4, dans lequel ladite étape de conditionnement (128) convertit des données formatées en blocs en des données formatées en lignes.

6. Procédé selon la revendication 3, 4 ou 5, comprenant en outre l'étape d'écriture de données formatées en blocs dans une mémoire (20) et de lecture des données formatées en blocs depuis ladite mémoire avant ladite étape de conditionnement d'affichage.
